Europäisches Patentamt

European Patent Office

Office européen des brevets

(11) Publication number: **0 404 507**
**A2**

# EUROPEAN PATENT APPLICATION

(21) Application number: **90306666.0**

(22) Date of filing: **19.06.90**

(51) Int. Cl.5: **G03F 3/10**

(30) Priority: **20.06.89 US 368698**

(43) Date of publication of application:
**27.12.90 Bulletin 90/52**

(84) Designated Contracting States:
**BE CH DE FR GB IT LI LU NL**

(71) Applicant: **HOECHST CELANESE CORPORATION**
**Route 202-206 North**
**Somerville, New Jersey(US)**

(72) Inventor: **Wanat, Stanley F.**
**3 Frances Lane**
**Scotch Plains, New Jersey(US)**

(74) Representative: **De Minvielle-Devaux, Ian Benedict Peter et al**
**CARPMAELS & RANSFORD 43, Bloomsbury Square**
**London WC1A 2RA(GB)**

(54) **Positive or negative working overlay color proofing system having photoresistive layer.**

(57) This invention relates to positive or negative photosensitized sheet constructions which, upon exposure to an actinic radiation source through a screened image, can accurately reproduce said image. The construction is useful as an overlay type color proofing film which can be employed to predict the image quality from a lithographic printing process.

EP 0 404 507 A2

## Background of the Invention

In the graphic arts, it is desirable to produce a color proof to assist a printer in correcting a set of photomasks which will be used in exposing printing plates. The proof should reproduce the color quality that will be obtained during the printing process. The proof must be a consistent duplicate of the desired halftone or line image, and should neither gain nor lose color. Visual examination of a color proof should reveal defects on the photomask; the best color rendition to be expected from press printing of the material; the correct gradation of all colors and whether grays are neutral; and the need, if any, for subduing any of the colors and/or giving directions for altering the film photomask before making the printing plates.

Color proofing sheets for multi-colored printing have heretofore been made by using a printing press proof which requires taking all the steps necessary for actual multicolor printing. Such a conventional method of color proofing has been costly and time consuming. Alternate color proofing methods have therefore been developed to simulate the quality of press proofs. There are two known types of photographic color proofing methods, namely, the surprint type and the overlay type.

In the overlay type of color proofing, an independent transparent plastic support is used for producing an image of each color separation film. A number of such supports carrying colored images are then superimposed upon each other and placed on a white sheet to produce a color proof. The overlay type of color proofing has the advantage that it is quick and can serve as a progressive proof by combining any two or more colors in register.

In the surprint type of color proofing, a color proofing sheet is prepared by successively producing images of different colors from different color separation films onto a single receptor sheet. This is done by utilizing a single opaque support and by applying toners, photosensitive solutions or coatings of photosensitive materials of corresponding colors on the opaque support in succession. An example of this approach is described in U.S. Patent No. 3,671,236. An advantage of the surprint type of color proof is that the color saturation is not influenced by superimposed plastic supports.

Various processes for producing copies of an image embodying photopolymerization and thermal transfer techniques are known as shown in U.S. Patent Nos. 3,060,023; 3,060,024; 3,060,025; 3,481,736; and 3,607,264. In these processes, a photopolymerizable layer coated on a suitable support is imagewise exposed to a photographic transparency. The surface of the exposed layer is the pressed into contact with the image receptive surface of a separate element and at least one of the elements is heated to a temperature above the transfer temperature of the unexposed portions of the layer. The two elements are then separated, whereby the thermally transferrable, unexposed, image areas of the composite transfer to the image receptive element. If the element is not precolored, the tacky unexposed image may now be selectively colored with a desired toner. The colored matter preferentially adheres to the clear unpolymerized material. U.S. patent No. 3,574,049 provides a transfer process for printing a design on a final support which comprises (a) printing a design onto a temporary support, (b) superimposing the temporary support and the final support, (c) applying heat and/or pressure to the superimposed structure formed in (b), and (d) separating the temporary support from the final support which retains the printed design. The affinity of the design for the temporary support is lower than its affinity for the final support.

In U.S. Patent No. 3,721,557 a method of transferring colored images is claimed which provides a stripping layer coated between the photosensitive element and the support. When the photosensitive layer is exposed to actinic light and developed, the more soluble portions are selectively removed to produce a visible image. The image-carrying support is pressed against a suitable adhesive coated receptor member and, subsequently, the carrier support sheet is stripped to accomplish the transfer of the image. A fresh layer of adhesive is applied to the receptor for each subsequent transfer.

U.S. Patent Nos. 4,650,738 and 4,659,642 describe improved transfer type color proofing films wherein colored photosensitive images are applied to a receiver sheet. Each color separated image appears directly connected to the next color separated image without transferring intermediate films. This invention provides an improved overlay type color proofing film by eliminating or reducing exposure interference between the colorants and photosensitizers used in the system by using an upper layer photosensitizer without added colorants. The upper layer acts like a photoresist for the colored, non-photosensitive underlying layer.

## Summary of the Invention

The invention provides a photosensitive article which comprises:

A. a transparent support, at least one major surface of which has been treated to promote the adhesion thereof to a subsequently applied coating; and

B. a colored layer directly adhered to said adhesion promoted surface, said layer being substantially free of light sensitive diazonium salt or quinone diazide compounds, said layer comprising in admixture an aqueous alkali soluble binder resin in sufficient amount to bind the colored layer components into a uniform film, and at least one colorant in sufficient amount to uniformly color said colored layer; and

C. a photosensitive layer directly adhered to said colored layer, said layer comprising a light sensitive film forming diazonium salt or quinone diazide in sufficient amount to cause an imagewise differentiation in said photosensitive layer upon imagewise exposure to sufficient imaging energy, said photosensitive layer being substantially free of added binders, dyes and pigments.

The invention also provides a method for producing a color proofing film which comprises:

I. providing a photosensitive article which comprises:

A. a transparent support, at least one major surface of which has been treated to promote the adhesion thereof to a subsequently applied coating; and

B. a colored layer directly adhered to said adhesion promoted surface, said layer being substantially free of light sensitive diazonium salt or quinone diazide compounds, said layer comprising in admixture an aqueous alkali soluble binder resin in sufficient amount to bind the colored layer components into uniform film, and at least one colorant in sufficient amount to uniformly color said colored layer; and

C. a photosensitive layer directly adhered to said colored layer, said layer comprising a light sensitive film forming diazonium salt or quinone diazide in sufficient amount to cause an imagewise differentiation in said photosensitive layer upon imagewise exposure to sufficient imaging energy, said photosensitive layer being substantially free of added binders, dyes and pigments; and

II. imagewise exposing the photosensitive layer to sufficient imaging energy to cause an imagewise differentiation in said photosensitive layer; and

III. removing the non-image portions of the photosensitive layer and the portions of the colored layer which underlay such non-image portions with an aqueous alkaline developer while substantially not removing the image portions of the photosensitive layer and the colored layer portions which underlay such image portions.


Detailed Description of the Preferred Embodiment


In carrying out the method of the invention, one prepares a photosensitive article which broadly comprises a support having an adhesion promoted surface, a colored layer on the adhesion promoted surface and photosensitive layer on the colored layer.

In the preferred embodiment, the support is composed of a dimensionally and chemically stable base material which does not significantly change its size, shape or chemical properties as the result of the coating or other treatments which it must undergo. A preferred material is polyethylene terephthalate. In the usual case, it has a thickness of from about 1 to about 10 mils, a more preferred thickness is from about 2 to about 5 mils and most preferably from about 2 to about 3 mils. Suitable films are Hostaphan 3000 and Hostaphan 4500, available from Hoechst Celanese Corporation; Mylar D, available from DuPont and Melinex grades 0; 052; 442; 516; 505 and S, available from ICI. The surface of the substrate may be smooth or may be provided with a matte texture by various methods known in the art.

The substrate must have an adhesive surface, that is, it must be capable of holding the colored layer thereto. This may be accomplished either by the substrate surface being inherently adhesive or being rendered adhesive by a suitable treatment, as with Melinex 505 or Hostaphan 4500.

One method improving adhesion is to provide the support with a matte surface.

A technique for improving adhesion involves a physical treatment of the base sheet prior to application of the light sensitive coating, such as roughening of the surface by sand blasting, by rubbing with abrasives, or by rubbing with brushes. This kind of mechanical treatment generally improves adhesion, but seriously reduces the transparency of the base material. Consequently, the finished proof sheets are less than satisfactory from a visual or color standpoint.

Another technique is as disclosed in U.S. Patents 2,627,088 and 3,481,736, wherein polyethylene terephthalate film may be coated or "subbed" with a thin adhesive layer composed of a terpolymer of vinylidene chloride/methyl acrylate/itaconic acid, which layer serves to anchor the subsequently applied resinous coating. When these subbed proof sheets are developed, it is found that the coating in the non-image areas of the proof sheet is readily removed and that the resolution and image clarity of the finished sheet are good.

Another adhesion promoter is composed in major proportion of a linear co-polyester obtained by forming an esterification product of a mixture of ethylene glycol from 20 to 60 mol percent based on the total amount of acids of terephthalic acid, about 15 to 50 mol percent of isophthalic acid, and about 10 to 65 mol percent of at least one acyclic dicarboxylic acid or acid ester selected from the group consisting of suberic, azelaic and adipic acids, and alkyl esters of these acids wherein the alkyl group contains from 1 to 7 carbon atoms. The linear polyesters are preferably prepared by reacting the aforementioned monomers under conditions effective to promote ester interchange to form the corresponding glycol esters under reduced pressure and in the presence of a polymerization catalyst to form the copolymer. Linear copolyesters having a relative viscosity within the range of about 1.3 to 7.0, determined as a solution of 0.6 gram of the copolyester in 100 grams of metacresol at 77° F, are most suitable for the purpose of this invention. A more complete description of the method for preparing the copolyesters upon which the adhesion promoter useful in the present invention is based may be found in U.S. Patents 2,465,319 and 4,157,918, the disclosures of which are incorporated herein by reference.

Bonded to the adhesion promoted surface is the colored layer. The colored layer broadly comprises a colorant and a binding resin.

Suitable binding resins for the colored layer non-exclusively include polyvinyl butyral, styrene maleic anhydride copolymer half esters, polymethyl methacrylate/methacrylic acid copolymers, polyvinyl acetals, acetals taught in U.S. 4,670,507, and mixtures thereof. Such resins include Butvar B72, B76 and B90 and Scripset 540 and 550, respectively, all available from Monsanto. An important resin selection criterion is that it must be a good film former.

The colorants useful for the present invention include various classes of dyes and pigments. In the most preferred embodiment, pigments having an average particle size of about 1 micrometer or less are used.

Preferred colorants for this invention are pigments rather than dyes. They are dispersed in a small amount of methyl ethyl ketone solvent and a styrene/maleic anhydride half acid isobutyl ester or an acetal terpolymer such as taught in U.S. Patent 4,670,507, which is incorporated herein by reference. The pigment particles are ground to a small enough particle size to duplicate the particle size and color of equivalent inks.

In the preferred embodiment, the colorant is present in the colored layer in an amount of from about 10 to about 40 percent by weight; or more preferably from about 13 to about 34 percent by weight.

In the preferred embodiment, the binding resin is present in the colored layer in an amount of from about 25 to about 80 parts by weight; or more preferably from about 32 to about 75 parts by weight.

These ingredients may be blended with such compatible solvents as ethanol, methyl Cellosolve and methyl ethyl ketone, coated on the adhesion promoted surface, and dried. In the preferred embodiment, the colored layer has a coating weight of from about 0.1 to about 5.0 g/m². The most preferred weight is from about 0.5 to about 2.0 g/m².

Finally, the photosensitive layer is applied to the colored layer. The photosensitive layer comprises a light sensitive film forming diazonium salt or quinone diazide compound in the absence of added dyes, pigments and binding resins.

The photosensitizer is preferably a light sensitive polymeric or oligomeric diazonium salt or naphthoquinone diazide. The most preferred quinone diazide photosensitizer is the ester of bis-(3-benzoyl-4,5,6 trihydroxy phenyl)-methane and 2-diazo-1-naphthol-5-sulfonyl chloride as taught in U.S. Patents 4,266,001; 3,106,365; 3,148,983; and 3,201,239.

The most preferred diazonium salt photosensitizer is the polycondensation product of 3-methoxy-4-diazo-diphenyl amine sulfate and 4,4'-bis-methoxymethyl-diphenyl ether, precipitated as mesitylene sulfonate or chloride salt as taught in U.S. Patent 3,849,392. Other suitable photosensitizers are taught in U.S. Patent 4,436,804. The diazo compounds of choice are preferably soluble in organic solvents. All of the foregoing patents are incorporated herein by reference.

An important photosensitizer selection criterion is that it must be a good film former. The photosensitive layer may also contain optional minor amounts of plasticizers, uv absorbers, anti-static compounds, acid stabilizers and surfactants as are well known in the art.

Optional plasticizers which may be incorporated into the photosensitive layer include those of the phthalate and phosphate types. Preferred plasticizers include dibutyl phthalate and dimethyl phthalate. Acid stabilizers include phosphoric acid and p-toluene sulfonic acid.

These ingredients may be blended with such compatible solvents as ethanol, methyl Cellosolve and methyl ethyl ketone. Preferably, the photosensitive layer has a coating weight of from about 0.1 to about 5.0 g/m². The most preferred coating weight is from about 0.5 to about 2.0 g/m².

4

In the preferred embodiment, the photosensitizer is present in the dried photosensitive layer in an amount of from about 90 to about 100 percent by weight of the layer. The plasticizer, when one is used, is present in the photosensitive layer in an amount of up to about 10 percent by weight of the layer.

The photosensitive layer is then imagewise exposed by means well known in the art. Such exposure may be conducted by exposure to a uv light source through a photomask under vacuum frame conditions. Exposure may be performed with actinic light through a conventional negative flat for the diazonium salt sensitizer or a positive flat for the quinone diazide compounds. Exposures are preferably conducted by emulsion-to-emulsion contact. Mercury vapor discharge lamps are preferred over metal halide lamps. Filters may be used to reduce light scattering in the material.

After exposure, the photosensitive layer is developed by dissolving the non-image area in a suitable developer and dried. Suitable developers non-exclusively include:

| I. | |
|---|---|
| water | 95.0 |
| sodium decyl sulphate | 3.0 |
| disodium phosphate | 1.5 |
| sodium metasilicate | 0.5 |
| II. | |
| water | 89.264 |
| monosodium phosphate | 0.269 |
| trisodium phosphate | 2.230 |
| sodium tetradecyl sulfate | 8.237 |

Any developer solution which satisfactorily removes the non-image areas of the photosensitive layer after exposure while retaining the image areas may be used. The selection of developer is well within the ability of the skilled artisan.

The process can then be repeated whereby additional photosensitive elements having different colors are laid over the previously formed image. In the usual case, four colored layers are employed to produce a full color reproduction of a desired image. These are cyan, magenta, yellow and black.

The following non-limiting examples serve to illustrate the invention.

Example 1

The following composition is formed and drawn down onto Melinex 505 using a #12 Meier rod and dried.

| Color Coating Solution | |
|---|---|
| Dowanol | 35.5g |
| methyl ethyl ketone (MEK) | 33.4g |
| diacetone alcohol (DAA) | 14.2g |
| Scripset 540 (styrene maleic anhydride resin) | 2.68g |
| Byk 301 | .03g |
| Blue pigment dispersion | 12.8g |

The following composition is formed and drawn down onto a sample of the above color coating with a #12 Meier rod and dried.

| Photosensitive Overcoat Solution | |
|---|---|
| Dowanol | 30.9g |
| methyl ethyl ketone | 38.7g |
| diacetone alcohol | 16.0g |
| Condensation product of 3-methoxy-4-diazo-diphenylamine sulfate and 4,4'-bis-methoxymethyl-diphenyl ether precipitated as the mesitylene sulfonate | 1.1g |

An exposure series is conducted through a test flat at 3,5,7 and 10 exposure units.

**Exposure      Stouffer Step**

3            clear 8        Gray level = 10

5            clear 9

7            clear 10

10           clear 11

*Gray level is calculated from the red, green and blue filter

density readings with a densitometer.  Gray = $\frac{Low}{High}$ x 100

## Example 2

Example 1 is repeated except the overcoat solution of example 1 is diluted in half with Dowanol, MEK and DAA. The amount of diazo in the top coating is reduced to 0.55g. The exposure series is repeated with the following results:

| Exposure | Stouffer Scale | |
|---|---|---|
| 3 | clear 8 | Gray Level = 8 |
| 5 | clear 9 | |
| 7 | clear 10 | |
| 10 | clear 11 | |

## Example 3

Example 2 is repeated except the overcoating solution is diluted in half again with Dowanol, MEK and DAA. The amount of diazo in the top coat is reduced 0.28g. It is overcoated onto the color sample and dried. The exposure series is repeated again with the following results:

6

| Exposure | Stouffer Scale | |
|---|---|---|
| 3.<br>5<br>7<br>10 | clear 8<br>clear 9<br>clear 10<br>clear 11 | Gray Level = 8 |

## Example 4

Example 3 is repeated except the composition is diluted fivefold with Dowanol, MEK and DAA. The amount of diazo present in the top coat is .06g. It is overcoated onto the color sample and dried. The exposure series is repeated again with the following results:

| Exposure | Stouffer Scale | |
|---|---|---|
| 3<br>7 | clear 5<br>clear 7 | Gray Level = 7 |

An analysis of the samples produced in examples 1-4 show a reduction in gray level, i.e., the color of the image is purer, compared to compositions where the photosensitizer and colorant are in admixture, because the amount of photosensitizer used can be reduced.

## Example 5

Positive Cyan Coating

The following compositions are prepared:

| | Control | Color Layer | Photosensitive Layer |
|---|---|---|---|
| | (grams) | (grams) | (grams) |
| Methyl Ethyl ketone (MEK) | 45 | 45 | 45 |
| Dowanol PM | 34 | 34 | 34 |
| Diacetone Alcohol (DAA) | 11 | 11 | 11 |
| Polymethyl methacrylate/methacylic acid | 0.83 | 0.83 | -- |
| Novolak Resin | 0.47 | 0.47 | -- |
| Victoria Pure Blue FGA | 1.1 | 1.1 | -- |
| Klucel MF (1.5% in Dowanol PM) | 5.2 | 5.2 | -- |
| ester of bis-(3-benzoyl-4,5,6-trihydroxy phenyl)-methane and 2-diazo-2-naphthol-5-sulfonyl chloride | 2.5 | -- | 2.5 |

## Sample A

· The control solution is coated onto Melinex 516 at an optical density (dried coating) of 1.7 using a Cosar densitometer. Gray = 17

## Sample B

The color layer composition without positive photosensitive compound is coated at an optical density of 1.6. The photosensitive layer is coated on top of the color coat to a dry coating density of 1.7. This sample simulates the control sample with the color layer separate from the photosensitive layer. Gray = 12

## Sample C

The photosensitive layer is diluted by 25% with of a 4/3/1: MEK/Dowanol PM/DAA solvent mix. This diluted photosensitive layer is coated on top of the color coating with 1.9 grams of the photosensitizer. Gray = 9

Samples A, B and C are imaged through a positive test flat in a vacuum frame (Berkey Ascor). The samples are developed in a aqueous alkaline developer, namely, NAPS/PAPS developer commercially available from Hoechst Celanese Corporation. Samples B and C have similar resolution at exposures ranging from 5-15 seconds, however sample B has 50% less gray and sample C 67% less gray than the control. Grayness is calculated from a series of densitometric measurements by the following:

$$\% \text{ gray} = \frac{L}{H} \times 100\%$$

where L = the low density reading among the readings with a red, green or blue filter and H = the high reading

## Claims

1. A photosensitive article which comprises:

A. a transparent support, at least one major surface of which has been treated to promote the adhesion thereof to a subsequently applied coating; and

B. a colored layer directly adhered to said adhesion promoted surface, said layer being substantially free of light sensitive diazo and diazide compounds, said layer comprising in admixture an aqueous alkali soluble binder resin in sufficient amount to bind the colored layer components into a uniform film, and at least one colorant in sufficient amount to uniformly color said colored layer; and

C. a photosensitive layer directly adhered to said colored layer, said layer comprising a light sensitive film forming diazonium salt or quinone diazide in sufficient amount to cause an imagewise differentiation in said photosensitive layer upon imagewise exposure to sufficient imaging energy, said photosensitive layer being substantially free of added binders, dyes and pigments.

2. The article of claim 1 wherein said transparent support comprises polyethylene terephthalate.

3. The article of claim 1 wherein said photosensitive layer further comprises one or more ingredients selected from the group consisting of plasticizers, acid stabilizers, antistatic compositions, uv absorbers and surfactants.

4. The article of claim 1 wherein the coating weight of the photosensitive layer ranges from about 0.1 to about 5.0g/m$^2$.

5. The article of claim 1 wherein said photosensitive layer comprises the polycondensation product of 3-methoxy-4-diazo-diphenyl amine sulfate and 4,4'-bis-methoxymethyl-diphenyl ether precipitated as the mesitylene sulfonate or chloride salt.

6. The article of claim 1 wherein said photosensitive layer comprises the ester of bis-(3-benzoyl-4,5,6 trihydroxyphenyl)-methane and 2-diazo-1-naphthol-5-sulfonyl chloride.

7. The article of claim 1 wherein the colored layer comprises a binding resin from the group consisting of polyvinyl acetals, styrene maleic anhydride copolymer; and polymethyl methacrylate/methacrylic acid copolymers.

8. The article of claim 1 wherein said support comprises polyethylene terephthalate, the binding resin in the colored layer comprises a resin selected from the group consisting of polyvinyl acetals, styrene maleic anhydride copolymers and polymethyl methacrylate/methacrylic acid copolymers, and said colored layer comprises at least one pigment.

9. A method for producing a color proofing film which comprises:

A. providing a photosensitive article which comprises:

1) a transparent support, at least one major surface of which has been treated to promote the adhesion thereof to a subsequently applied coating; and

2) a colored layer directly adhered to said adhesion promoted surface, said layer being substantially free of light sensitive diazo and diazide compounds, said layer comprising in admixture an aqueous alkali soluble binder resin in sufficient amount to bind the colored layer components into a uniform film, and at least one colorant in sufficient amount to uniformly color said colored layer; and

3) a photosensitive layer directly adhered to said colored layer, said photosensitive layer comprising a light sensitive film forming diazonium salt or quinone diazide in sufficient amount to cause an imagewise differentiation in said photosensitive layer upon imagewise exposure to sufficient imaging energy, said photosensitive layer being substantially free of added binders, dyes and pigments; and

B. imagewise exposing the photosensitive layer to sufficient imaging energy to cause an imagewise differentiation in said photosensitive layer; and

C. removing the non-image portions of the photosensitive layer and the portions of the colored layer which underlay such non-image portions with a liquid developer while substantially not removing the image portions of the photosensitive layer and the colored layer portions which underlay such image portions.

10. The method of claim 9 wherein said transparent support comprises polyethylene terephthalate.

11. The method of claim 9 wherein said photosensitive layer further comprises one or more ingredients selected from the group consisting of plasticizers, acid stabilizers, antistatic compositions, uv absorbers and surfactants.

12. The method of claim 9 wherein the coating weight of the photosensitive layer ranges from about 0.1 to about 5.0 g/m$^2$.

13. The method of claim 9 wherein said photosensitive layer comprises the polycondensation product of 3-methoxy-4-diazo-diphenyl amine sulfate and 4,4′-bis-methoxymethyl-diphenyl ether precipitated as the mesitylene sulfonate or chloride salt.

14. The method of claim 9 wherein said photosensitive layer comprises the ester of bis-(3-benzoyl-4,5,6 trihydroxyphenyl)-methane and 2-diazo-1-naphthol-5-sulfonic acid.

15. The method of claim 9 wherein the colored layer comprises a binding resin from the group consisting of polyvinyl acetals, styrene/maleic anhydride copolymer, and polymethyl methacrylate/methacrylic acid copolymers.

16. The method of claim 9 wherein said support comprises polyethylene terephthalate, and the binding resin in the colored layer comprises a resin selected from the group consisting of polyvinyl acetals, styrene/maleic anhydride copolymers and polymethyl methacrylate/methacrylic acid copolymers, and said colored layer comprises at least one pigment.

17. The method of claim 9 wherein said exposing step is conducted with ultraviolet radiation.

18. The method of claim 9 wherein said removing step (c) is conducted with an aqueous alkaline developer.

19. The method of claim 9 wherein said developer is organic solvent free.

20. The method of claim 18 wherein said developer is organic solvent free.